# EUROPEAN PATENT SPECIFICATION

(11) **EP 4 354 166 B1**
(45) Date of publication and mention of the grant of the patent: **04.11.2026**
(21) Application number: 22836612.6
(22) Date of filing: 17.05.2022
(51) Int. Cl.: G01R 31/396, G01R 31/385, G01R 31/387, G01R 31/367, G01R 31/36, G01R 31/3832, G01R 31/382, H02J 7/82

(54) **METHOD AND APPARATUS FOR CALCULATING REMAINING DISCHARGE TIME, AND COMPUTER DEVICE**
VERFAHREN UND VORRICHTUNG ZUR BERECHNUNG DER VERBLEIBENDEN ENTLADUNGSZEIT UND COMPUTERVORRICHTUNG
PROCÉDÉ ET APPAREIL POUR CALCULER LE TEMPS DE DÉCHARGE RESTANT ET DISPOSITIF INFORMATIQUE

(30) Priority: 06.07.2021 CN 202110763349
(43) Date of publication of application: 17.04.2024
(73) Proprietor: EcoFlow Inc., Shenzhen, Guangdong 518000 (CN)
(72) Inventor: WANG, Lei, Shenzhen, Guangdong 518000 (CN); CHEN, Xi, Shenzhen, Guangdong 518000 (CN)
(74) Representative: Appelt, Christian W.
(86) International application number: PCT/CN2022/093236
(87) International publication number: WO 2023/279856

(56) References cited:
- EP-A1- 3 069 923
- CN-A- 102 655 549
- CN-A- 105 527 574
- CN-A- 110 133 506
- CN-A- 110 470 995
- CN-A- 111 064 174
- CN-A- 112 748 347
- CN-A- 112 858 924
- CN-A- 113 640 691
- JP-A- 2001 051 030
- JP-A- 2002 050 408
- JP-A- 2011 030 395
- JP-A- 2011 030 395
- JP-A- H06 119 941
- US-A- 5 631 540
- US-A1- 2017 003 351

## Description

### CROSS-REFERENCE TO RELATED APPLICATIONS

This application claims priority to Chinese Patent Application No. 202110763349.0, filed with the China National Intellectual Property Administration on July 6, 2021 and entitled "METHOD AND APPARATUS FOR CALCULATING DISCHARGE REMAINING TIME, AND COMPUTER DEVICE".

### TECHNICAL FIELD

This application relates to the field of energy storage device management, and in particular, to a method and apparatus for calculating a discharge remaining time, and a computer device.

### BACKGROUND

The descriptions herein merely provide background information related to this application, and do not necessarily constitute exemplary techniques.

When an energy storage device (such as a battery) is discharging, it is generally calculated based on a current remaining power and discharge current of the energy storage device to obtain a discharge remaining time. However, when the discharge current is sampled, current sampling jitter is likely to occur, which leads to an inaccurate discharge remaining time obtained in subsequent calculations.

EP 3 069 923 A1 describes an estimation method of a residual electric vehicle range, the vehicle having a battery pack and at least an electric motor cooperating with a vehicle transmission, the method comprising in a cyclic succession: acquisition of a residual energy, calculation of a residual range as the ratio given by said residual energy divided by a predetermined kilometric consumption coefficient and calculation of a residual discharge time of the vehicle batteries as the ratio of said residual range divided by a vehicle speed, identification of a corrective parameter of said residual energy value and function of said residual discharge time, acquisition of said residual energy and correction of the same by means of said corrective parameter.

### SUMMARY

The present invention relates to a method according to claim 1, an apparatus according to claim 9, and a computer device according to claim 10. Claims 2 to 8 refer to specifically advantageous realizations of the method according to claim 1.

### BRIEF DESCRIPTION OF THE DRAWINGS

To describe technical solutions in embodiments or exemplary techniques of this application more clearly, the following briefly describes the accompanying drawings for describing the embodiments or the exemplary techniques. It is clear that the accompanying drawings in the following description are merely some embodiments of this application, and a person of ordinary skilled in the art may still derive drawings of other embodiments from these accompanying drawings without creative efforts.
FIG. 1 is a schematic diagram of steps of a method for calculating a discharge remaining time according to an embodiment of this application.
FIG. 2 is an overall structural block diagram of an apparatus for calculating a discharge remaining time according to an embodiment of this application.
FIG. 3 is an overall structural block diagram of an apparatus for calculating a discharge remaining time according to another embodiment of this application.
FIG. 4 is a schematic structural block diagram of a computer device according to an embodiment of this application.

The realization of the purpose, functional features and advantages of this application will be further described in conjunction with the embodiments and with reference to the accompanying drawings.

### DETAILED DESCRIPTION

To make purposes, technical solutions, and advantages of this application clearer, the following further describes this application in detail in conjunction with the accompanying drawings and embodiments. It should be understood that the specific embodiments described herein are intended only to explain this application and are not intended to have a limitation on the application.

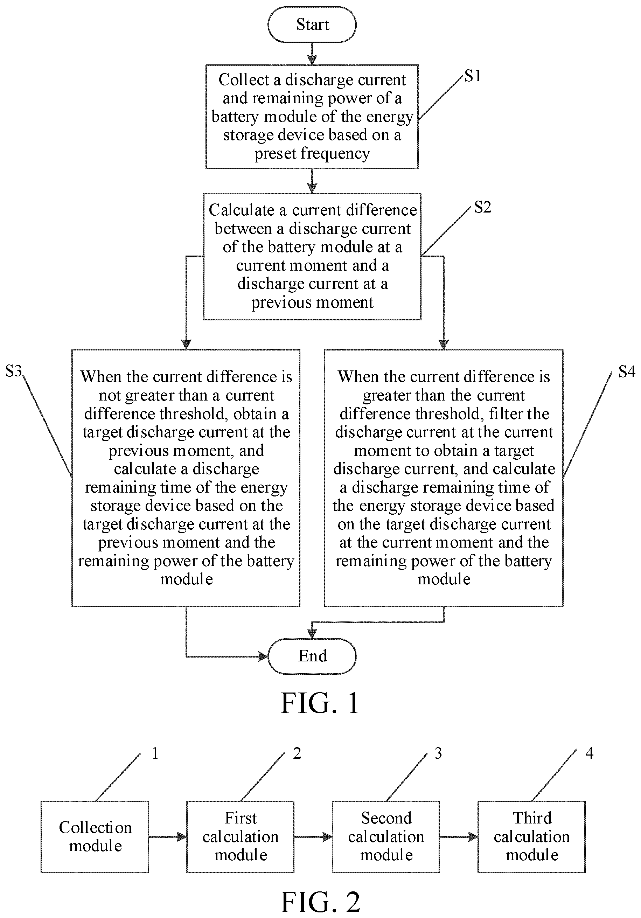

Refer to FIG. 1. An embodiment of this application provides a method for calculating a discharge remaining time, applied to an energy storage device, including the following steps.

S1. Collect a discharge current and remaining power of a battery module of the energy storage device based on a preset frequency.

S2. Calculate a current difference between a discharge current of the battery module at a current moment and a discharge current at a previous moment.

S3. When the current difference is not greater than a current difference threshold, obtain a target discharge current at the previous moment, and calculate the discharge remaining time of the energy storage device based on the target discharge current at the previous moment and the remaining power of the battery module.

S4. When the current difference is greater than the current difference threshold, filter the discharge current at the current moment to obtain a target discharge current, and calculate the discharge remaining time of the energy storage device based on the target discharge current at the current moment and the remaining power of the battery module.

In this embodiment, a management system of the energy storage device samples the discharge current of the battery module of the energy storage device based on the preset frequency, and after collecting a new discharge current each time, calculates the discharge remaining time based on the discharge current and the remaining power of the energy storage device. In this embodiment, a discharge remaining time at a certain moment is taken as an example to describe in detail. After sampling the discharge current at the current moment, the management system calls a discharge current at an adjacent previous moment. Then, calculate a current difference between the discharge current at the current moment and the discharge current at the previous moment (where the current difference represents an amplitude of change between discharge currents collected at two adjacent moments), and determine whether the current difference is greater than a current threshold. A specific value of the current threshold is set based on standby power consumption of the energy storage device and a sampling error range of the current during standby, and is not specified here. If the current difference between the discharge current at the current moment and the discharge current at the previous moment is not greater than the current threshold, it is considered that the discharge current sampled at the two adjacent moments has not changed, and there is no need to re-perform a first-order filtering calculation of the discharge current. At this time, the management system obtains the target discharge current at the previous moment, and calculates the target discharge current at the previous moment based on the remaining power of the energy storage device at the current moment and the target discharge current at the previous moment, to obtain a discharge remaining time. In this application, the target discharge current represents the discharge current obtained by filtering the discharge current that is output by the battery module of the energy storage device. Specifically, the target discharge current of the discharge current can be obtained by bringing the discharge current of the battery module into a filter formula.

If the current difference between the discharge current at the current moment and the discharge current at the previous moment is greater than the current threshold, it is necessary to calculate a new target discharge current based on the discharge current at the current moment, to enable the target discharge current at the current moment after calculation to be close to an actual current as soon as possible. In this application, a first-order, second-order or high-order filtering algorithm can be used for filtering processing on the discharge current. The first-order filtering and second-order filtering will not have too much lag in data processing. In this application, the first-order filtering algorithm is used to filter the discharge current. In other embodiments, if an amplitude of change in time is required to be more stable, the second-order filtering algorithm or a higher-order filtering algorithm can be used. In this application, the management system calls the first-order filtering algorithm after modifying a filter coefficient, and calculates the target discharge current at the current moment based on the discharge current at the current moment. A general formula of the first-order filtering algorithm is Y(n)=aX(n)+(1-a)Y(n-1), where Y(n) is an output value of this filtering, Y(n-1) is an output value of last filtering, X(n) is a sampling value of this time, and a is the filter coefficient. In an actual application, a corresponding type of sampling value and filter coefficient can be set based on an actual requirement, and no specific limitation is made thereto. Finally, the management system calculates the remaining discharge time based on the target discharge current at the current moment and the remaining power of the energy storage device.

In this embodiment, the management system performs amplitude limiting jitter processing on the sampled discharge current. When the current difference between the discharge current at the current moment and the discharge current at the previous moment is not greater than the current threshold, it is considered that the sampled discharge current has not changed, so the target discharge current at the previous moment is directly used to calculate the discharge remaining time, which is convenient and efficient. However, when the current difference between the discharge current at the current moment and the discharge current at the previous moment is greater than the current threshold, a new target discharge current (that is, the target discharge current at the current moment) is recalculated to make the filtered current close to the actual current as soon as possible, thus improving an update speed and accuracy of the discharge remaining time. It should be noted that in this application, the energy storage device includes a display module, and the display module includes a display screen that can display relevant data based on a preset display mode. After calculating the discharge remaining time of the energy storage device, the management system sends the discharge remaining time to the display module, and the display module will display the discharge remaining time based on the preset display mode. In this application, the management system collects a discharge current of a power module of the energy storage device and calculates a discharge remaining time every 250 milliseconds, and then updates a display value of the display module of the energy storage device every 1 second. In other embodiments, if there is a speed requirement for the calculation of the remaining time, a current sampling frequency and a time calculation frequency can be modified.

Further, the step of filtering the discharge current at the current moment to obtain a target discharge current includes the following steps.

S401. Call a first filter coefficient.

S402. Calculate the target discharge current at the current moment based on the discharge current at the current moment, the discharge current at the previous moment, the first filter coefficient and a preset filter formula.

The preset filter formula is: *I = K*₁ × *I*₁ + (1 *- K*₁) × *I*₀, where I represents the target discharge current at the current moment, K₁ represents the first filter coefficient, I₁ represents the discharge current at the current moment, and I₀ represents the discharge current at the previous moment.

In this embodiment, the management system calls the first filter coefficient, and the first filter coefficient is preferably 0.95. The management system substitutes the discharge current at the current moment, the discharge current at the previous moment and the first filter coefficient into the preset filter formula for calculation, to obtain the required target discharge current at the current moment. The preset filter formula is: *I = K*₁ × *I*₁ *+* (1 - *K*₁) × *I*₀, where I is the target discharge current at the current moment, K₁ is the first filter coefficient, I₁ is the discharge current at the current moment, and I₀ is the discharge current at the previous moment. In this embodiment, 0.95 is preferred as the first filter coefficient with high sensitivity, and the calculated target discharge current at the current moment is less affected by the sampled discharge current at the previous moment, which can be closer to an actual discharge current of the energy storage device to the greatest extent, thus improving the update speed and accuracy of the discharge remaining time.

Further, after the step of calculating a target discharge current at the current moment, the method further includes the following steps.

S403. Store the target discharge current at the current moment in a target current database, where the target current database stores a target discharge current corresponding to each moment.

Preferably, the step of obtaining a target discharge current at the previous moment includes the following steps.

S301. Read a target current database.

S302. Obtain a discharge current corresponding to the previous moment in the target current database, and use the discharge current as the target discharge current.

In this embodiment, after calculating the target discharge current at the current moment, the management system stores the target discharge current at the current moment in a pre-constructed target current database. That is, after the target discharge current is calculated each time, the target discharge current is put into the target current database and stored to form a historical record, which is convenient for technicians to retrieve and view when needed. Preferably, in an actual application process, the management system reads a discharge current corresponding to a previous moment adjacent to a current moment from the target current database based on the current moment, and takes the discharge current as the target discharge current at the previous moment, and adds the subsequent discharge remaining time to the calculation.

Further, after the step of collecting a discharge current and remaining power of a battery module of the energy storage device based on a preset frequency, the method includes the following steps.

S5. Determine whether the discharge current of the battery module is collected for the first time.

S6. Call a second filter coefficient if the discharge current of the battery module is collected for the first time, where the second filter coefficient is less than the first filter coefficient.

S7. Calculate a target discharge current that is collected for the first time based on the discharge current of the battery module, the second filter coefficient and a preset filter algorithm.

S8. Calculate the discharge remaining time of the energy storage device based on the target discharge current that is collected for the first time and the remaining power.

In this embodiment, the management system determines whether it is the first time to collect the discharge current of the battery module of the energy storage device. If the discharge current of the battery module is collected for the first time, there is no comparison between the discharge current at the previous moment and the discharge current at the current moment. At this time, the management system calls a default second filter system to filter and calculate the discharge current, where the second filter coefficient is smaller than the first filter coefficient, and the second filter coefficient is preferably 0.05, which is less sensitive than the first filter coefficient, but a filtering result is more stable. The management system calculates the target discharge current that is collected for the first time based on the discharge current of the battery module, the second filter coefficient and the preset filter algorithm. Finally, the management system obtains a current remaining power of the energy storage device, divides the current remaining power by the target discharge current that is collected for the first time, and a resulting value is the discharge remaining time of the energy storage device at the current moment. In this embodiment, the preset filter algorithm is a first-order filter algorithm.

Further, the step of calculating the discharge remaining time based on the target discharge current of the discharge current at the current moment includes the following steps.

S303. Obtain the current remaining power of the energy storage device.

S304. Calculate the discharge remaining time based on the current remaining power and the target discharge current of the discharge current at the current moment.

In this embodiment, the management system obtains the current remaining power of the energy storage device, and substitutes the current remaining power and the target discharge current of the discharge current at the current moment into a calculation formula, to obtain a discharge remaining time. The calculation formula is $T = \frac{RC}{I} \times 60$, where T is the discharge remaining time, a unit of which is expressed in minutes, RC is the current remaining power, and I represents the target discharge current at the current moment. Specifically, a unit of RC is mAh, a unit of I is mA, and a numerical value obtained by RC/I is a number of remaining hours. In this application, the number of remaining hours is multiplied by 60 to get a number of remaining minutes in order for a user to know the detailed remaining time more intuitively. In other embodiments, a corresponding remaining time display mode can be set, such as a number of displayed remaining seconds. Preferably, when the management system calculates the discharge remaining time of the energy storage device based on the target discharge current of the discharge current at the previous moment, the calculation formula is the same. That is, the target discharge current of the discharge current at the previous moment is used as the target discharge current of the discharge current at the current moment, and the current remaining power of the energy storage device is substituted to calculate the discharge remaining time.

Further, after the step of calculating the discharge remaining time of the energy storage device based on the target discharge current at the current moment and the remaining power of the battery module, the method includes the following steps.

S9. Determine whether the discharge remaining time of the energy storage device is less than a time threshold.

S10. Output the discharge remaining time of the energy storage device to a display interface if the discharge remaining time of the energy storage device is not less than the time threshold.

S11. If the discharge remaining time of the energy storage device is less than the time threshold, output the discharge remaining time of the energy storage device to the display interface, and perform a reminder action.

In this embodiment, the time threshold is set in the management system. The time threshold represents an alarm limit of the discharge remaining time of the energy storage device, and can be customized by the user as needed. Each time the management system obtains a new discharge remaining time, it will compare the discharge remaining time with the time threshold. The management system determines whether the discharge remaining time is less than the time threshold. If the discharge remaining time is not less than the time threshold, the discharge remaining time is output to the display interface for display without reminding the user, so that the user can timely understand the discharge remaining time of the energy storage device. If the discharge remaining time is less than the time threshold, in order to remind the user, the management system will not only output the discharge remaining time to the display interface, but also perform the reminder action (such as alarm sound, light flashing, etc.) to remind the user, so that the user can timely replace the energy storage device, or charge the energy storage device.

Further, the step of outputting the discharge remaining time of the energy storage device to the display interface, and performing a reminder action includes the following steps.

S1101. Match a corresponding display color based on a ratio of the discharge remaining time of the energy storage device to the time threshold.

S1102. Output, in the display color, the discharge remaining time of the energy storage device to the display interface.

In this embodiment, the reminder action is preferably to change the display color of the discharge remaining time. Specifically, the management system uses the time threshold as a denominator and the discharge remaining time as a numerator, to calculate the ratio of the discharge remaining time to the time threshold. Then, match the corresponding display color based on the ratio, where an internal database of the management system stores a ratio-display color mapping table, and the ratio-display color mapping table includes a plurality of sets of one-to-one corresponding ratios and display colors. Based on the ratio calculated at the current time, the management system selects the corresponding display color from the ratio-display color mapping table. Then, the discharge remaining time is output to the display interface in a matched display color for display. In this embodiment, by displaying the discharge remaining time in different display colors, the user is enabled to more intuitively understand a change of the discharge remaining time of the energy storage device.

Further, after the step of calculating the discharge remaining time of the energy storage device based on the target discharge current at the current moment and the remaining power of the battery module, the method further includes the following steps.

S12. Sequentially obtain discharge remaining times at several adjacent collection time points.

S13. Respectively calculate a difference between two adjacent discharge remaining times, to obtain several time change values.

S14. Determine, based on each time change value, whether an attenuation trend of the discharge remaining time increases.

S15. Output prompt information if the attenuation trend of the discharge remaining time increases, where the prompt information is used for prompting the user to limit power of a discharge device connected to the energy storage device.

In this embodiment, the management system sequentially obtains the discharge remaining times at the several adjacent collection time points from a historical records of the discharge remaining time of the energy storage device. The management system calculates the difference between the two adjacent discharge remaining times, and obtains the several time change values. The time change value represents an amplitude of change of the discharge remaining time of the energy storage device. That is, the greater the time change value, the greater the amplitude of change of the discharge remaining time between two adjacent moments. The management system determines whether the attenuation trend of the discharge remaining time increases based on each time change value sorted in order. Specifically, the management system calculates a difference between two adjacent time change values. If the difference is not 0 or greater than an amplitude threshold (where the amplitude threshold is set by a developer based on parameters of the energy storage device and the discharge device), the management system determines that the attenuation trend of the discharge remaining time increases. The management system outputs the prompt information, and the prompt information is used for prompting the user to limit the power of the discharge device connected to the energy storage device, to avoid damage to the energy storage device due to excessive discharge.

Refer to FIG. 2. An embodiment of this application further provides an apparatus for calculating a discharge remaining time, applied to an energy storage device, including:
a collection module 1, configured to collect a discharge current and remaining power of a battery module of the energy storage device based on a preset frequency;
a first calculation module 2, configured to calculate a current difference between a discharge current of the battery module at a current moment and a discharge current at a previous moment;
a second calculation module 3, configured to: when the current difference is not greater than a current difference threshold, obtain a target discharge current at the previous moment, and calculate the discharge remaining time of the energy storage device based on the target discharge current at the previous moment and the remaining power of the battery module; and
a third calculation module 4, configured to: when the current difference is greater than the current difference threshold, filter the discharge current at the current moment to obtain a target discharge current, and calculate the discharge remaining time of the energy storage device based on the target discharge current at the current moment and the remaining power of the battery module.

Further, the third calculation module 4 includes:
a call unit, configured to call a first filter coefficient; and
a calculation unit, configured to calculate the target discharge current at the current moment based on the discharge current at the current moment, the discharge current at the previous moment, the first filter coefficient and a preset filter formula.

The preset filter formula is: *I = K*₁ × *I*₁ + (1 *- K*₁) × *I*₀*,* where *I* represents the target discharge current at the current moment, K₁ represents the first filter coefficient, I₁ represents the discharge current at the current moment, and I₀ represents the discharge current at the previous moment.

Further, the third calculation module 4 further includes:
a storage unit, configured to store the target discharge current at the current moment in a target current database, where the target current database stores a target discharge current corresponding to each moment.

Further, the second calculation module 3 includes:
a reading unit, configured to read a target current database; and
an obtaining unit, configured to obtain a discharge current corresponding to the previous moment in the target current database, and use the discharge current as the target discharge current.

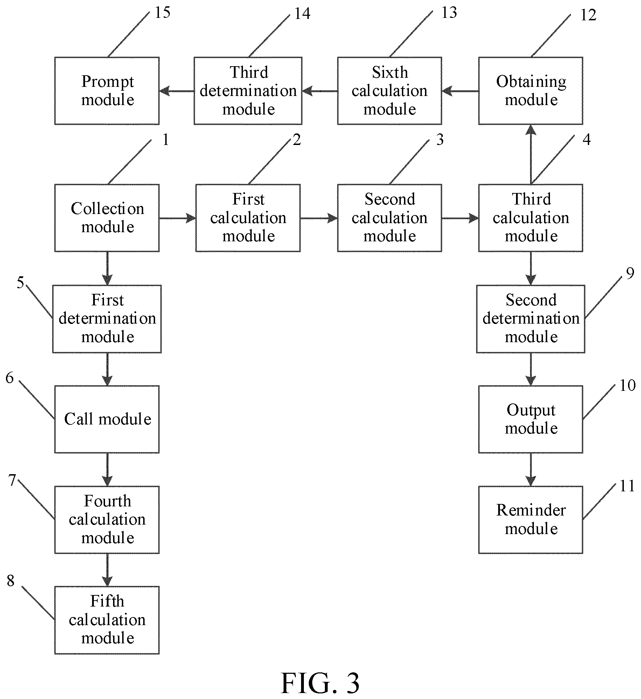

Further, as shown in FIG. 3, the apparatus for calculating a discharge remaining time further includes:
a first determination module 5, configured to determine whether the discharge current of the battery module is collected for the first time;
a call module 6, configured to call a second filter coefficient if the discharge current of the battery module is collected for the first time, where the second filter coefficient is less than the first filter coefficient;
a fourth calculation module 7, configured to calculate a target discharge current that is collected for the first time based on the discharge current of the battery module, the second filter coefficient and a preset filter algorithm; and
a fifth calculation module 8, configured to calculate the discharge remaining time of the energy storage device based on the target discharge current that is collected for the first time and the remaining power.

Further, the apparatus for calculating a discharge remaining time includes:
a second determination module 9, configured to determine whether the discharge remaining time of the energy storage device is less than a time threshold;
an output module 10, configured to output the discharge remaining time of the energy storage device to a display interface when it is determined that the discharge remaining time of the energy storage device is not less than the time threshold; and
a reminder module 11, configured to: when it is determined that the discharge remaining time of the energy storage device is less than the time threshold, output the discharge remaining time of the energy storage device to the display interface, and perform a reminder action.

Further, the reminder module includes:
a matching unit, configured to match a corresponding display color based on a ratio of the discharge remaining time of the energy storage device to the time threshold; and
an output unit, configured to output, in the display color, the discharge remaining time of the energy storage device to the display interface.

Further, the apparatus for calculating a discharge remaining time further includes:
an obtaining module 12, configured to sequentially obtain discharge remaining times at several adjacent collection time points;
a sixth calculation module 13, configured to respectively calculate a difference between two adjacent discharge remaining times, to obtain several time change values;
a third determination module 14, configured to determine, based on each time change value, whether an attenuation trend of the discharge remaining time increases; and
a prompt module 15, configured to output prompt information when it is determined that the attenuation trend of the discharge remaining time increases, where the prompt information is used for prompting a user to limit power of a discharge device connected to the energy storage device.

In this embodiment, each module and unit in the apparatus is obtained to correspondingly execute each step in the foregoing method for calculating a discharge remaining time, and the specific implementation process is not described in detail here.

This embodiment provides an apparatus for calculating a discharge remaining time. For the beneficial effects of the apparatus for calculating a discharge remaining time performing the method for calculating a discharge remaining time, reference may be made to any of the foregoing embodiments. The apparatus for calculating a discharge remaining time may be provided in the energy storage device. The apparatus for calculating a discharge remaining time may obtain a discharge current and remaining power of a battery module of the energy storage device, and calculate a discharge remaining time of the battery module accordingly.

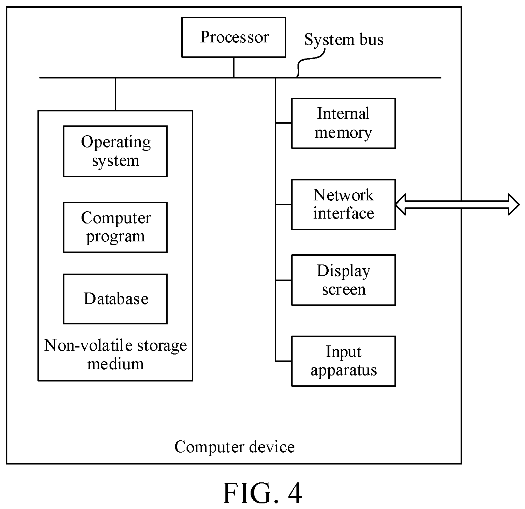

Refer to FIG. 4. Embodiments of this application further provide a computer device. The computer device may be a server, and its internal structure may be shown in FIG. 4. The computer device includes a processor, a memory, a network interface and a database connected through a system bus. The processor designed by the computer is configured to provide computing and control capabilities. The memory of the computer device includes a non-volatile storage medium and an internal memory. The non-volatile storage medium stores an operating system, a computer program, and a database. The internal memory provides an environment for the operation of the operating system and the computer program in the non-volatile storage medium. The database of the computer device is used to store data such as a current threshold. The network interface of the computer device is used to communicate with an external terminal through a network connection. The computer program is executed by the processor to implement the method for calculating a discharge remaining time provided by any of the foregoing embodiments, which is applicable to the energy storage device.

An embodiment of this application further provides a computer-readable storage medium. A computer program is stored on the computer-readable storage medium. When the computer program is executed by a processor, the method for calculating a discharge remaining time provided by any of the foregoing embodiments is implemented. A person of ordinary skill in the art may understand that all or some of the processes of the method embodiments may be implemented by instructing relevant hardware through a computer program. The computer program may be stored in a non-volatile computer-readable storage medium. When executed, the computer program may include the processes of the foregoing method embodiments. Any references to memories, storage, databases or other media provided in this application and used in embodiments may include a non-volatile and/or volatile memory. The non-volatile memory may include a read-only memory (ROM), a programmable ROM (PROM), an electrically programmable ROM (EPROM), an electrically erasable programmable ROM (EEPROM), or a flash memory. The volatile memory may include a random access memory (RAM) or an external cache. As an illustration rather than a limitation, the RAM is available in many forms, such as a static RAM (SRAM), a dynamic RAM (DRAM), a synchronous DRAM (SDRAM), a double data rate SDRAM (DDRSDRAM), an enhanced SDRAM (ESDRAM), a synchlink (Synchlink) DRAM (SLDRAM), a rambus (Rambus) direct RAM (RDRAM), a direct rambus dynamic RAM (DRDRAM), and a rambus dynamic RAM (RDRAM).

It should be noted that the terms "include", "comprise", or any other variation thereof in this specification is intended to cover a non-exclusive inclusion, such that processes, apparatuses, first objects or methods including a series of elements not only include those elements, but also other elements not expressly listed or elements inherent to the processes, apparatuses, first objects or methods. Without more limitations, elements defined by the sentence "including one ..." does not exclude that there are still other same elements in the processes, apparatuses, first objects, or methods including the elements.

The above are only preferred embodiments of this application, and do not limit the patent scope of this application.

## Claims

1. A method for calculating a discharge remaining time, applied to an energy storage device, comprising:
sampling a discharge current and remaining power of a battery module of the energy storage device based on a preset frequency (S1);
calculating a current difference between a discharge current of the battery module sampled at a current moment and a discharge current sampled at a previous moment (S2);
when the current difference is not greater than a current difference threshold, obtaining a target discharge current at the previous moment, and calculating the discharge remaining time of the energy storage device based on the target discharge current at the previous moment and the remaining power of the battery module (S3); and
when the current difference is greater than the current difference threshold, using a filtering algorithm for processing the discharge current at the current moment to obtain a target discharge current, and calculating the discharge remaining time of the energy storage device based on the target discharge current at the current moment and the remaining power of the battery module (S4).

2. The method for calculating a discharge remaining time according to claim 1, wherein the step of filtering the discharge current at the current moment to obtain a target discharge current comprises:
calling a first filter coefficient; and
calculating the target discharge current at the current moment based on the discharge current at the current moment, the discharge current at the previous moment, the first filter coefficient and a preset filter formula, wherein
the preset filter formula is: *I = K*₁ × *I*₁ + (1 - *K*₁) × *I*₀, wherein *I* represents the target discharge current at the current moment, K₁ represents the first filter coefficient, I₁ represents the discharge current at the current moment, and I₀ represents the discharge current at the previous moment.

3. The method for calculating a discharge remaining time according to claim 2, wherein after the step of calculating the target discharge current at the current moment, the method further comprises:
storing the target discharge current at the current moment in a target current database, wherein the target current database stores a target discharge current corresponding to each moment.

4. The method for calculating a discharge remaining time according to claim 1, wherein the step of obtaining a target discharge current at the previous moment comprises:
reading a target current database; and
obtaining a discharge current corresponding to the previous moment in the target current database, and using the discharge current as the target discharge current.

5. The method for calculating a discharge remaining time according to claim 2, wherein after the step of sampling a discharge current and remaining power of a battery module of the energy storage device based on a preset frequency, the method further comprises:
determining whether the discharge current of the battery module is sampled for the first time;
calling a second filter coefficient if the discharge current of the battery module is sampled for the first time, wherein the second filter coefficient is less than the first filter coefficient;
calculating a target discharge current that is sampled for the first time based on the discharge current of the battery module, the second filter coefficient and a preset filter algorithm; and
calculating the discharge remaining time of the energy storage device based on the target discharge current that is sampled for the first time and the remaining power.

6. The method for calculating a discharge remaining time according to claim 1, wherein after the step of calculating the discharge remaining time of the energy storage device based on the target discharge current at the current moment and the remaining power of the battery module, the method comprises:
determining whether the discharge remaining time of the energy storage device is less than a time threshold;
outputting the discharge remaining time of the energy storage device to a display interface if the discharge remaining time of the energy storage device is not less than the time threshold; and
if the discharge remaining time of the energy storage device is less than the time threshold, outputting the discharge remaining time of the energy storage device to the display interface, and performing a reminder action.

7. The method for calculating a discharge remaining time according to claim 6, wherein the step of outputting the discharge remaining time of the energy storage device to the display interface, and performing a reminder action comprises:
matching a corresponding display color based on a ratio of the discharge remaining time of the energy storage device to the time threshold; and
outputting, in the display color, the discharge remaining time of the energy storage device to the display interface.

8. The method for calculating a discharge remaining time according to claim 1, wherein after the step of calculating the discharge remaining time of the energy storage device based on the target discharge current at the current moment and the remaining power of the battery module, the method further comprises:
sequentially obtaining discharge remaining times at several adjacent sampling time points;
respectively calculating a difference between two adjacent discharge remaining times, to obtain several time change values;
determining, based on each time change value, whether an attenuation trend of the discharge remaining time increases; and
outputting prompt information if the attenuation trend of the discharge remaining time increases, wherein the prompt information is used for prompting a user to limit power of a discharge device connected to the energy storage device.

9. An apparatus for calculating a discharge remaining time, applied to an energy storage device, comprising:
a collection module (1), configured to sample a discharge current and remaining power of a battery module of the energy storage device based on a preset frequency;
a first calculation module (2), configured to calculate a current difference between a discharge current of the battery module sampled at a current moment and a discharge current sampled at a previous moment;
a second calculation module (3), configured to: when the current difference is not greater than a current difference threshold, obtain a target discharge current at the previous moment, and calculate the discharge remaining time of the energy storage device based on the target discharge current at the previous moment and the remaining power of the battery module; and
a third calculation module (4), configured to: when the current difference is greater than the current difference threshold, use a filtering algorithm for processing the discharge current at the current moment to obtain a target discharge current, and calculate the discharge remaining time of the energy storage device based on the target discharge current at the current moment and the remaining power of the battery module.

10. A computer device, comprising a memory and a processor, wherein the memory stores a computer program, and when executing the computer program, the processor implements the steps of the method according to any one of claims 1 to 8.

## Patentansprüche

1. Verfahren zur Berechnung einer verbleibenden Entladungszeit, angewandt auf eine Energiespeichervorrichtung, umfassend:
Abtasten eines Entladungsstroms und einer verbleibenden Leistung eines Batteriemoduls der Energiespeichervorrichtung auf der Grundlage einer voreingestellten Frequenz (S1);
Berechnen einer Stromdifferenz zwischen einem Entladungsstrom des Batteriemoduls, der zu einem aktuellen Zeitpunkt abgetastet wird, und einem Entladungsstrom, der zu einem vorherigen Zeitpunkt abgetastet wurde (S2);
wenn die Stromdifferenz nicht größer als eine Stromdifferenzschwelle ist, Ermitteln eines Ziel-Entladungsstroms zum vorherigen Zeitpunkt und Berechnen der verbleibenden Entladungszeit der Energiespeichervorrichtung auf der Grundlage des Ziel-Entladungsstroms zum vorherigen Zeitpunkt und der verbleibenden Leistung des Batteriemoduls (S3); und
wenn die Stromdifferenz größer als die Stromdifferenzschwelle ist, Verwenden eines Filteralgorithmus zum Verarbeiten des Entladungsstroms zum aktuellen Zeitpunkt, um einen Ziel-Entladungsstrom zu ermitteln, und Berechnen der verbleibenden Entladungszeit der Energiespeichervorrichtung auf der Grundlage des Ziel-Entladungsstroms zum aktuellen Zeitpunkt und der verbleibenden Leistung des Batteriemoduls (S4).

2. Verfahren zum Berechnen einer verbleibenden Entladungszeit nach Anspruch 1, wobei der Schritt vom Filtern des Entladungsstroms zum aktuellen Zeitpunkt, um einen Ziel-Entladungsstrom zu ermitteln, umfasst:
Aufrufen eines ersten Filterkoeffizienten; und
Berechnen des Ziel-Entladungsstroms zum aktuellen Zeitpunkt auf der Grundlage des Entladungsstroms zum aktuellen Zeitpunkt, des Entladungsstroms zum vorherigen Zeitpunkt, des ersten Filterkoeffizienten und einer voreingestellten Filterformel, wobei
die voreingestellte Filterformel lautet: *I = K₁* × *I₁* + *(I - K₁*) × *I₀,* wobei I den Ziel-Entladungsstrom zum aktuellen Zeitpunkt darstellt, K₁ den ersten Filterkoeffizienten darstellt, I₁ den Entladungsstrom zum aktuellen Zeitpunkt darstellt und I₀ den Entladungsstrom zum vorherigen Zeitpunkt darstellt.

3. Verfahren zur Berechnung einer verbleibenden Entladungszeit nach Anspruch 2, wobei das Verfahren nach dem Schritt vom Berechnen des Ziel-Entladungsstroms zum aktuellen Zeitpunkt ferner umfasst:
Speichern des Ziel-Entladungsstroms zum aktuellen Zeitpunkt in einer Ziel-Stromdatenbank, wobei die Ziel-Stromdatenbank entsprechend jedem Zeitpunkt einen Ziel-Entladungsstrom speichert.

4. Verfahren zur Berechnung einer verbleibenden Entladungszeit nach Anspruch 1, wobei der Schritt vom Ermitteln eines Ziel-Entladungsstroms zum vorherigen Zeitpunkt Folgendes umfasst:
Auslesen einer Ziel-Stromdatenbank; und
Ermitteln eines Entladungsstroms, der dem vorherigen Zeitpunkt in der Ziel-Stromdatenbank entspricht, und Verwenden des Entladungsstroms als den Ziel-Entladungsstrom.

5. Verfahren zur Berechnung einer verbleibenden Entladungszeit nach Anspruch 2, wobei das Verfahren nach dem Schritt vom Abtasten eines Entladungsstroms und einer verbleibenden Leistung eines Batteriemoduls der Energiespeichervorrichtung auf der Grundlage einer voreingestellten Frequenz ferner umfasst:
Bestimmen, ob der Entladungsstrom des Batteriemoduls zum ersten Mal abgetastet wird;
Aufrufen eines zweiten Filterkoeffizienten, wenn der Entladungsstrom des Batteriemoduls zum ersten Mal abgetastet wird, wobei der zweite Filterkoeffizient kleiner als der erste Filterkoeffizient ist;
Berechnen eines Ziel-Entladungsstroms, der zum ersten Mal abgetastet wird, auf der Grundlage des Entladungsstroms des Batteriemoduls, des zweiten Filterkoeffizienten und eines voreingestellten Filteralgorithmus; und
Berechnen der verbleibenden Entladungszeit der Energiespeichervorrichtung auf der Grundlage des Ziel-Entladungsstroms, der zum ersten Mal abgetastet wird, und der verbleibenden Leistung.

6. Verfahren zur Berechnung einer verbleibenden Entladungszeit nach Anspruch 1, wobei das Verfahren nach dem Schritt vom Berechnen der verbleibenden Entladungszeit der Energiespeichervorrichtung auf der Grundlage des Ziel-Entladungsstroms zum aktuellen Zeitpunkt und der verbleibenden Leistung des Batteriemoduls, umfasst:
Bestimmen, ob die verbleibende Entladungszeit der Energiespeichervorrichtung kleiner als eine Zeitschwelle ist;
Ausgeben der verbleibenden Entladungszeit der Energiespeichervorrichtung an eine Anzeigeoberfläche, wenn die verbleibende Entladungszeit der Energiespeichervorrichtung nicht kleiner als die Zeitschwelle ist; und
wenn die verbleibende Entladungszeit der Energiespeichervorrichtung kleiner als die Zeitschwelle ist, Ausgeben der verbleibenden Entladungszeit der Energiespeichervorrichtung an die Anzeigeoberfläche und Durchführen einer Erinnerungsmaßnahme.

7. Verfahren zur Berechnung einer verbleibenden Entladungszeit nach Anspruch 6, wobei der Schritt vom Ausgeben der verbleibenden Entladungszeit der Energiespeichervorrichtung an die Anzeigeoberfläche und vom Durchführen einer Erinnerungsmaßnahme umfasst:
Anpassen einer entsprechenden Anzeigefarbe auf der Grundlage eines Verhältnisses der verbleibenden Entladungszeit der Energiespeichervorrichtung zu der Zeitschwelle; und
Ausgeben, in der Anzeigefarbe, der verbleibenden Entladungszeit der Energiespeichervorrichtung an die Anzeigeoberfläche.

8. Verfahren zur Berechnung einer verbleibenden Entladungszeit nach Anspruch 1, wobei das Verfahren nach dem Schritt vom Berechnen der verbleibenden Entladungszeit der Energiespeichervorrichtung auf der Grundlage des Ziel-Entladungsstroms zum aktuellen Zeitpunkt und der verbleibenden Leistung des Batteriemoduls ferner umfasst:
aufeinanderfolgendes Ermitteln verbleibender Entladungszeiten zu mehreren benachbarten Abtastzeitpunkten;
jeweiliges Berechnen einer Differenz zwischen zwei benachbarten verbleibenden Entladungszeiten, um mehrere Zeitänderungswerte zu ermitteln;
Bestimmen, auf der Grundlage jedes Zeitänderungswerts, ob ein Abschwächungstrend der verbleibenden Entladungszeit zunimmt; und
Ausgeben von Anweisungsinformationen, wenn der Abschwächungstrend der verbleibenden Entladungszeit zunimmt, wobei die Anweisungsinformationen zum Anweisen eines Benutzers verwendet werden, eine Leistung einer Entladungsvorrichtung, die mit der Energiespeichervorrichtung verbunden ist, zu begrenzen.

9. Vorrichtung zur Berechnung einer verbleibenden Entladungszeit, die auf eine Energiespeichervorrichtung angewendet wird, umfassend:
ein Sammelmodul (1), das so konfiguriert ist, dass es einen Entladungsstrom und eine verbleibende Leistung eines Batteriemoduls der Energiespeichervorrichtung auf der Grundlage einer voreingestellten Frequenz abtastet;
ein erstes Berechnungsmodul (2), das so konfiguriert ist, dass es eine Stromdifferenz zwischen einem Entladungsstrom des Batteriemoduls, der zu einem aktuellem Zeitpunkt abgetastet wird, und einem Entladungsstrom, der zu einem vorherigen Zeitpunkt abgetastet wurde, berechnet;
ein zweites Berechnungsmodul (3), das so konfiguriert ist, dass es: wenn die Stromdifferenz nicht größer als eine Stromdifferenzschwelle ist, einen Ziel-Entladungsstrom zum vorherigen Zeitpunkt ermittelt und die verbleibende Entladungszeit der Energiespeichervorrichtung auf der Grundlage des Ziel-Entladungsstroms zum vorherigen Zeitpunkt und der verbleibenden Leistung des Batteriemoduls berechnet; und
ein drittes Berechnungsmodul (4), das so konfiguriert ist, dass es: wenn die Stromdifferenz größer als die Stromdifferenzschwelle ist, einen Filteralgorithmus zum Verarbeiten des Entladungsstroms zum aktuellen Zeitpunkt verwendet, um einen Ziel-Entladungsstrom zu ermitteln, und die verbleibende Entladungszeit der Energiespeichervorrichtung auf der Grundlage des Ziel-Entladungsstroms zum aktuellen Zeitpunkt und der verbleibenden Leistung des Batteriemoduls berechnet.

10. Computervorrichtung, umfassend einen Speicher und einen Prozessor, wobei der Speicher ein Computerprogramm speichert und der Prozessor bei der Ausführung des Computerprogramms die Schritte des Verfahrens nach einem der Ansprüche 1 bis 8 implementiert.

## Revendications

1. Procédé de calcul d'un temps de décharge restant, appliqué à un dispositif de stockage d'énergie, comprenant :
échantillonnage d'un courant de décharge et d'une puissance restante d'un module de batterie du dispositif de stockage d'énergie sur la base d'une fréquence prédéfinie (S1) ;
calcul d'une différence de courant entre un courant de décharge du module de batterie échantillonné à un instant actuel et un courant de décharge échantillonné à un instant précédent (S2) ;
lorsque la différence de courant n'est pas supérieure à un seuil de différence de courant, obtention d'un courant de décharge cible à l'instant précédent, et calcul du temps de décharge restant du dispositif de stockage d'énergie sur la base du courant de décharge cible à l'instant précédent et de la puissance restante du module de batterie (S3) ; et
lorsque la différence de courant est supérieure au seuil de différence de courant, utilisation d'un 1lgoritme de filtrage pour traiter le courant de décharge à l'instant actuel afin d'obtenir un courant de décharge cible, et calcul du temps de décharge restant du dispositif de stockage d'énergie sur la base du courant de décharge cible à l'instant actuel et de la puissance restante du module de batterie (S4).

2. Procédé de calcul d'un temps de décharge restant selon la revendication 1, lequel comprend, pour l'étape de filtrage du courant de décharge à l'instant actuel afin d'obtenir un courant de décharge cible :
appel d'un premier coefficient de filtrage ; et
calcul du courant de décharge cible à l'instant actuel sur la base du courant de décharge à l'instant actuel, du courant de décharge à l'instant précédent, du premier coefficient de filtrage et d'une formule de filtrage prédéfinie, laquelle
formule de filtrage prédéfinie est : I = K₁ ×I₁ + (1 - K₁) ×I₀, dans laquelle I représente le courant de décharge cible à l'instant actuel, K₁ représente le premier coefficient de filtrage, I₁ représente le courant de décharge à l'instant actuel, et I₀ représente le courant de décharge à l'instant précédent.

3. Procédé de calcul d'un temps de décharge restant selon la revendication 2, lequel, après l'étape de calcul du courant de décharge cible à l'instant actuel, comprend en outre :
stockage du courant de décharge cible à l'instant actuel dans une base de données de courant cible, laquelle base de données de courant cible stocke un courant de décharge cible correspondant à chaque instant.

4. Procédé de calcul d'un temps de décharge restant selon la revendication 1, lequel comprend, pour l'étape d'obtention d'un courant de décharge cible à l'instant précédent :
lecture d'une base de données de courant cible ; et
obtention d'un courant de décharge correspondant à l'instant précédent dans la base de données de courant cible, et utilisation du courant de décharge comme courant de décharge cible.

5. Procédé de calcul d'un temps de décharge restant selon la revendication 2, dans lequel, après l'étape d'échantillonnage d'un courant de décharge et d'une puissance restante d'un module de batterie du dispositif de stockage d'énergie sur la base d'une fréquence prédéfinie, comprend en outre :
détermination si le courant de décharge du module de batterie est échantillonné pour la première fois ;
appel d'un second coefficient de filtrage si le courant de décharge du module de batterie est échantillonné pour la première fois, lequel second coefficient de filtrage est inférieur au premier coefficient de filtrage ;
calcul d'un courant de décharge cible qui est échantillonné pour la première fois sur la base du courant de décharge du module de batterie, du second coefficient de filtrage et d'un algorithme de filtrage prédéfini ; et
calcul du temps de décharge restant du dispositif de stockage d'énergie sur la base du courant de décharge cible qui est échantillonné pour la première fois et de la puissance restante.

6. Procédé de calcul d'un temps de décharge restant selon la revendication 1, lequel, après l'étape de calcul du temps de décharge restant du dispositif de stockage d'énergie sur la base du courant de décharge cible à l'instant actuel et de la puissance restante du module de batterie, comprend :
détermination si le temps de décharge restant du dispositif de stockage d'énergie est inférieur à un seuil de temps ;
sortie du temps de décharge restant du dispositif de stockage d'énergie vers une interface d'affichage si le temps de décharge restant du dispositif de stockage d'énergie n'est pas inférieur au seuil de temps ; et
si le temps de décharge restant du dispositif de stockage d'énergie est inférieur au seuil de temps, sortie du temps de décharge restant du dispositif de stockage d'énergie vers l'interface d'affichage, et exécution d'une action de rappel.

7. Procédé de calcul d'un temps de décharge restant selon la revendication 6, lequel comprend, pour l'étape de sortie du temps de décharge restant du dispositif de stockage d'énergie vers l'interface d'affichage, et d'exécution d'une action de rappel :
appariement d'une couleur d'affichage correspondante sur la base d'un rapport du temps de décharge restant du dispositif de stockage d'énergie au seuil de temps ; et
sortie, dans la couleur d'affichage, du temps de décharge restant du dispositif de stockage d'énergie vers l'interface d'affichage.

8. Procédé de calcul d'un temps de décharge restant selon la revendication 1, lequel, après l'étape de calcul du temps de décharge restant du dispositif de stockage d'énergie sur la base du courant de décharge cible à l'instant actuel et de la puissance restante du module de batterie, comprend en outre :
obtention séquentielle de temps de décharge restants à plusieurs points de temps d'échantillonnage adjacents ;
calcul respectif d'une différence entre deux temps de décharge restants adjacents, afin d'obtenir plusieurs valeurs de variation de temps ;
détermination, sur la base de chaque valeur de variation de temps, si une tendance d'atténuation du temps de décharge restant augmente ; et
sortie d'une information d'alerte si la tendance d'atténuation du temps de décharge restant augmente, laquelle information d'alerte est utilisée pour alerter un utilisateur de limiter la puissance d'un dispositif de décharge connecté au dispositif de stockage d'énergie.

9. Appareil de calcul d'un temps de décharge restant, appliqué à un dispositif de stockage d'énergie, comprenant :
un module de collecte (1), qui est configuré pour échantillonner un courant de décharge et une puissance restante d'un module de batterie du dispositif de stockage d'énergie sur la base d'une fréquence prédéfinie ;
un premier module de calcul (2), qui est configuré pour calculer une différence de courant entre un courant de décharge du module de batterie échantillonné à un instant actuel et un courant de décharge échantillonné à un instant précédent ;
un second module de calcul (3), qui est configuré pour : lorsque la différence de courant n'est pas supérieure à un seuil de différence de courant, obtenir un courant de décharge cible à l'instant précédent, et calculer le temps de décharge restant du dispositif de stockage d'énergie sur la base du courant de décharge cible à l'instant précédent et de la puissance restante du module de batterie ; et
un troisième module de calcul (4), qui est configuré pour : lorsque la différence de courant est supérieure au seuil de différence de courant, utiliser un 3lgoritme de filtrage pour traiter le courant de décharge à l'instant actuel afin d'obtenir un courant de décharge cible, et calculer le temps de décharge restant du dispositif de stockage d'énergie sur la base du courant de décharge cible à l'instant actuel et de la puissance restante du module de batterie.

10. Dispositif informatique, comprenant une mémoire et un processeur, la mémoire stockant un programme informatique, et lors de l'exécution du programme informatique, le processeur mettant en oeuvre les étapes du procédé selon l'une quelconque des revendications 1 à 8.
